(19) Europäisches Patentamt
European Patent Office
Office européen des brevets

(11) Publication number: **0 163 089**
**B1**

# (12) EUROPEAN PATENT SPECIFICATION

(45) Date of publication of patent specification: **10.08.88**

(51) Int. Cl.[4]: **H 05 K 3/18**, G 03 F 7/02, C 23 C 18/16

(21) Application number: **85104589.8**

(22) Date of filing: **17.04.85**

## (54) Process for activating a substrate for electroless deposition of a conductive metal.

(30) Priority: **25.04.84 US 603791**

(43) Date of publication of application:
**04.12.85 Bulletin 85/49**

(45) Publication of the grant of the patent:
**10.08.88 Bulletin 88/32**

(84) Designated Contracting States:
**DE FR GB**

(56) References cited:
**EP-A-0 002 795**
**GB-A-1 191 215**
**US-A-3 672 925**

(73) Proprietor: **International Business Machines Corporation**
**Old Orchard Road**
**Armonk, N.Y. 10504 (US)**

(72) Inventor: **Jones, Gerald Walter**
**1112 Reynolds Road**
**Johnson City New York 13790 (US)**
Inventor: **Lawrence, William Howell**
**Rd 3 Box 228**
**Greene New York 13778 (US)**
Inventor: **Rovente, Frederick Michael**
**Rd 2**
**Binghamton New York 13903 (US)**

(74) Representative: **Kreidler, Eva-Maria, Dr. rer. nat.**
**Schönaicher Strasse 220**
**D-7030 Böblingen (DE)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention is concerned with the seeding of at least one major surface of a dielectric substrate to prepare the substrate for the electroless deposition of a conductive metal thereon. The present invention finds particular applicability for the manufacture of printed circuit cards and boards.

In the manufacture of printed circuit cards and boards, a dielectric sheet material is employed as the substrate. A conductive circuit pattern is provided on one or both of the major surfaces of the substrate.

A conductive pattern can be formed on the surface of the substrate using a variety of known techniques. These known techniques include the subtractive technique where a layer of copper is etched to form the desired circuit pattern, the EDB (electroless direct bond) technique where copper is electrolessly plated directly on the surface of the substrate in the desired pattern, and the peel-apart technique where the desired circuit pattern is plated up from a thin layer of peel-apart copper.

If it is desired to use the EDB technique, it is necessary to plate directly on the surface of the substrate.

Since the dielectric substrate is nonconductive, in order to plate on the substrate, the substrate must be seeded or catalyzed prior to the deposition of metal onto the substrate. The seeder, in addition to coating the substrate, also coats the walls of the holes or vias of the board.

In addition, in order to provide patterned metal surfaces on the substrate, a resist material is applied above the seeder.

The resist can be applied, for instance, by laminating a dry film of the resist to the surface. The layer of resist material is then selectively exposed to the desired pattern by a known technique, such as ultraviolet light, electron beam, or X-ray beam technique, followed by removal of the exposed portions in the case of positive-resist materials and unexposed portions in the case of negative-resist materials, by etching or dissolution in an appropriate liquid. Next, the surface is plated with a metal which is deposited on those areas of the surface which are not protected by the patterned resist material. When an appropriate thickness of metal has been deposited, the resist may be removed, leaving behind a patterned metal conductive surface.

Certain problems, however, can occur with the above procedure. In particular, the adhesion of the resist can degrade due to the presence of the seeder beneath the resist layer. This is especially significant for electroless plating processes which require relatively long residence time in the plating bath. Loss of adhesion of the resist to the substrate can result in improperly plated lines.

For instance, defects such as nicks in the lines and plating voids occur sometimes. This, in turn, results in defective printed circuit boards which must be discarded.

Moreover, seeder which might remain on unplated portions after the plating can result in decreasing the insulation resistance between adjacent conductive lines.

The present invention provides for an improved process of activating at least one major surface of a dielectric substrate for subsequent plating.

The object of the invention is achieved by a process according to claim 1.

According to the present invention, the seeder is present only where plating is desired on the substrate. The process of the present invention thereby eliminates the problem of loss of resist adhesion due to the seeder beneath the resist. The present invention also reduces the problem of decreased insulation resistance.

Procedures have been suggested for seeding only the vias, but not for selectively seeding at least one major surface of the substrate. For instance, when seeding the holes or vias, the entire rest of the top surface is covered with a resist so that the seeder goes onto the walls in the vias and onto the top of the resist. Next, the resist is stripped away, thereby removing all of the seeder that is on the top surface of the board.

In another technique, the seeding of the holes or vias is done while the top carrier layer of the peel-apart copper is still on the board. Therefore, the seeding material goes onto the carrier layer of the peel-apart, and when the carrier layer is removed, the only remaining seeder is in the through holes.

Contrary to the above technique, the present invention provides seeder on predetermined areas of at least one major surface of the substrates and, if present, also in the holes or vias.

According to the present invention, preselected portions of at least one major surface of the dielectric substrate are activated for subsequent electroless deposition of a conductive metal. The process includes providing a first resist layer onto a major surface of the substrate and a second resist layer onto the first resist layer.

The second resist has different solubility characteristics than those of the first resist. The first and second resists are exposed to imaging radiation in a predetermined pattern. Each of the first and second resists is developed. The resulting exposed portions of the substrate are then seeded. The second resist layer is removed from the structure while retaining the first resist layer. This results in removal of all seeder, except from the exposed areas of the substrate.

Figures 1—9 schematically illustrate a sequence of steps suitable for carrying out the process of the present invention.

The process of the present invention is applicable to treating or conditioning a wide variety of dielectric (non-conductor) substrates. Dielectric substrates described in the prior art, including thermoplastic and thermosetting resins and glass, may be treated in accordance with the present invention.

Typical thermosetting polymeric materials include epoxy, phenolic based materials, and polyamides. The dielectric materials may be

molded articles of the polymers containing fillers and/or reinforcing agents such as glass-filled epoxy or phenolic based materials. Examples of some phenolic type materials include copolymers of phenol, resorcinol, and cresol. Examples of some suitable thermoplastic polymeric materials include polyolefins such as polypropylene, polysulfones, polycarbonates, nitrile rubbers, and ABS polymers.

Although the main purpose of the present invention is for seeding at least one of the major surfaces of the substrate, the plated through holes or vias and/or blind holes of the substrate, when present, can likewise be seeded.

Prior to the initiation of the process of the present invention for treating the dielectric substrate, the holes, if present in the circuit board, are made and the dielectric with the holes is suitably cleaned and preconditioned.

For instance, the preconditioning can include creation of active sites by physical means such as sand and/or vapor blasting and/or chemical methods such as solvent swelling. A typical solvent is N-methyl pyrrolidone. The substrate can also be pretreated with a sulfochromic acid-composition.

A layer 2 of a first resist material is applied to the substrate 1 (see Figure 1). A second resist material 3 is applied onto the first resist layer 2 (see Figure 2). If desired, a composite of the first resist material and of the second resist material can be obtained and then the composite applied to the substrate 1. The second resist layer 3 has solubility characteristics which differ from solubility characteristics of the first layer 2. The differences in solubility characteristics make it possible, after development, to subsequently remove the second resist layer without removing the first layer. The first and second layers can be developable in the same development solvents as long as they have solubility characteristics for the stripping or removal thereof which differ from each other.

The resists which can be employed according to the present invention include both positive and negative resists. The layers can both be positive or negative resists, or one layer can be positive while the other is negative. It is preferred that the layers both be positive or negative resists.

Examples of some photoresists employed according to the present invention include negative or photohardenable polymerizable compositions of the type suggested in U.S. Patents 3,469,982; 3,526,504; 3,867,153; and 3,448,098; and published European Patent Application 0049504. Polymers from methylmethacrylate and from glycidyl acrylate and/or from a polyacrylate such as trimethylol propane triacrylate and pentaerythritol triacrylate are commercially available from E. I. du Pont de Nemours and Company under the trade designation "Riston".

Examples of some negative photoresists employed according to the present invention are from polymethylmethacrylates such as those commercially available from E. I. du Pont de Nemours and Company under the trade designations "Riston T—168" and "Riston 3515". T—168 is a negative photoresist material from polymethylmethacrylate and crosslinkable monomeric units such as from trimethylol propane triacrylate. A detailed discussion of preparing a negative resist from polymethylmethacrylate, trimethylol propane triacrylate and trimethylene glycol diacetate can be found in Example 1 of U.S. Patent 3,867,153. Riston 3515 is a negative photoresist material which is developable in an aqueous medium. Examples of aqueous developable negative photoresists are described in published European Patent Application 0049504 such as Example 23 thereof. A typical resist described therein is from a copolymer of methylmethacrylate, ethyl acrylate, and acrylic acid; and a copolymer of styrene and maleic anhydride isobutyl ester.

An example of another type of photoresist is based on phenol formaldehyde novolak polymers. A particular example of such is Shipley AZ1350 which is an m-cresol formaldehyde novolak polymer composition. Such is a positive resist composition and includes therein, diazoketone, such as 2-diazo-1-naphthol-5-sulphonic acid ester. In such a composition, the orthodiazoketone, during the photochemical reaction, is converted to a carboxylic acid. This, in turn, converts a neutral-organic soluble molecule (the phenolic polymer) to one that is readily soluble in weakly alkali aqueous developer solvents. The composition usually contains about 15% or so, by weight, of the diazoketone compound.

The first resist layer is generally applied in thicknesses of at least the desired thickness of the subsequently plated metal and usually about 0.005 mm greater than the subsequently to be plated metal. Typical thicknesses of the first layer are about 0.025 to about 0.102 mm and preferably about 0.038 to 0.064 mm.

The second resist layer is usually about 0.0064 to about 0.038 mm thick, and is preferably about 0.013 to about 0.025 mm thick. The maximum thickness of the second photoresist layer is merely dictated by the optical density of the second layer and must be thin enough to permit the imaging radiation such as actinic light to penetrate the first and bottom layer 2. The resists can be applied, for instance, by lamination such as a hot roll lamination at temperatures of about 90°C to about 120°C and preferably about 110°C; and pressures of about $3.43 \times 10^4$ Pa to about $20.58 \times 10^4$ Pa and preferably about $6.86 \times 10^4$ Pa to $10.29 \times 10^4$ Pa.

Each layer of resist material is then selectively exposed to the desired pattern and imaged by a known technique such as ultraviolet light, electron beam, or X-ray beam technique, followed by removal of the exposed portions in the case of positive resist materials by etching or dissolution in an appropriate liquid. In the case of negative resist materials, the unexposed portions are removed. In addition, it is contemplated that the

first resist layer is applied and imaged and also, if desired, developed prior to applying the second resist layer.

Figure 3 illustrates providing a mask 4 to expose the resist layers 2 and 3 to the desired pattern. In this example the resist layers 2 and 3 are negative resists and the portions of layers 2 and 3 lying under the opaque portion 7 of the mask are not exposed to the imaging radiation.

After development of the resist layers (see Figures 4 and 5), seeder or catalyst composition 5 is applied to the entire structure, including the exposed portions of the substrate (see Figure 6). When the second resist layer is an aqueous developable resist such as Riston 3515, it can be developed with an aqueous sodium carbonate solution of the type suggested in Published European Patent Application 0049504. When the first resist layer is Riston T—168, it can be developed employing 1,1,1-trichloroethane.

Methods for seeding are well-known. For instance, among the more widely employed procedures for catalyzing a substrate is the use of a stannous chloride sensitizing solution and a palladium chloride activator to form a layer of metallic palladium particles. For instance, one method for catalyzing a dielectric substrate is exemplified by U.S. Patent 3,011,920 which includes sensitizing the substrate by treating it with a solution of a colloidal metal, accelerating the treatment with a selective solvent to remove protective colloids for the sensitized dielectric substrate, and then electrolessly depositing a metal coating on the sensitized substrate, for example, with copper from a solution of a copper salt and a reducing agent.

Also, as suggested for example, in U.S. Patent 3,099,608, a dielectric substrate can be pretreated by depositing a thin film of a "conductivator" type of metal particle such as palladium metal from a semicolloidal solution onto the dielectric substrate to provide a conducting base which permits electroplating with conductive metal on the conductivated base. Moreover, U.S. Patent 3,632,388 suggests a method for treating a polymeric plastic substrate in a plating process which utilizes a preliminary chromic acid etch followed by a one step activation in a tin-palladium hydrosol.

More recently, U.S. Patent 4,066,809 discloses the use of a so-called "triple seeding" technique. This technique, preferred in U.S. Patent 4,066,809, includes contacting the surfaces of the dielectric material with an aqueous palladium chloride/stannous chloride/hydrochloric acid seeder bath.

In the preferred aspect of the present invention, prior to the stannous chloride and palladium chloride treatment, the substrate is treated with an aqueous solution containing a multifunctional ionic polymer, as disclosed in British Patent 1,383,105.

The polymer is a multifunctional ionic material in that it must contain at least two active or available ionic functional moieties of the same polarity. The polymers are at least water-miscible and are preferably water-soluble or at least soluble in the water compositions employed in the present invention. The preferred ionic moieties are cationic moieties such as quaternary phosphonium and quaternary ammonium groups. Polymers containing at least two ionic moieties are commercially available and need not be described herein in any great detail. Examples of commercially available multifunctional cationic polymers are Reten 210, Retgen 220, and Reten 300, available from Hercules, description of which can be found in "Water-Soluble Polymers", Bulletin VC—482A, Hercules Incorporated, Wilmington, Delaware 19899.

Reten 210 is in powder form and is a copolymer of acrylamide and betamethacryloxyethyl trimethylammonium methyl sulfate having a Brookfield viscosity of a 1% solution of 0.6 to 1.0 Pa·s.

Reten 220 is in powder form and is a copolymer of acrylamide and betamethacryloxyethyl-trimethylammonium methyl sulfate having a Brookfield viscosity of a 1% solution of 0.8 to 1.2 Pa·s.

Reten 300 is a liquid and is a homopolymer of betamethacryloxyethyl trimethylammonium methyl sulfate having a Brookfield viscosity of a 1% solution of 0.3 to 0.7 Pa·s.

The molecular weight of the Reten polymers are usually relatively high and vary from about 50,000 to about 1,000,000 or more. These high molecular weight polymers are solid products and their main chemical backbone structure is polyacrylamide. The cationic Reten (positive charge) is obtained by attaching to the polyacrylamide various tetraalkyl ammonium compounds. These quaternary ammonium groups provide the number of positive charges of the polymer.

In the preferred aspects of the present invention, the ionic polymer is employed as a dilute aqueous solution of about 0.01 to about 1% by weight and preferably, about 0.05 to about 0.5% by weight of the copolymer.

The aqueous solution also usually contains an inorganic acid, such as HCl, to provide a pH of about 1 to about 7 and preferably a pH of about 2 to about 3. The use of a pH of about 2 to about 3 is preferred in order to obtain a relatively low viscosity for the polymer solution to facilitate application of the polymer. The viscosity drastically increases when the pH is above about 4 to 5. The acid is usually present in amounts of about 2 to about 10% by weight.

The treatment with the ionic polymer is generally about 1 to about 10 minutes and preferably about 1 to about 2 minutes.

The multifunctional polymer provides a surface being of a polarity opposite from that associated with the catalyst particles to be subsequently applied to the substrate. This difference in polarity provides for electrostatic attraction of the catalyst particles.

When a multifunctional polymer is employed, loss of adhesion by the photoresist is especially pronounced when the process of the present invention is not followed.

After the substrate is contacted with the ionic polymer composition, the substrate is rinsed to remove any excess polymer not adsorbed by the substrate.

Next, the substrate is activated by contact with a composition containing a catalytic composition capable of initiating the electroless plating process. The compounds contain a metal which can directly provide the catalytic sites or serves as a precursor which leads to the catalytic sites. The metal present may be in the elemental form, an alloy, or compound, or mixtures thereof. The preferred metal catalysts are precious metals such as gold, palladium, and platinum. In addition, in view of the improved conditioning of the substrate achieved by employing the multifunctional polymer, the catalyst can be a nonprecious metal such as copper, nickel, cobalt, iron, zinc, manganese, and aluminum.

The most preferred catalyst is palladium. A typical palladium composition contains about 1.2 to 2.5 g/l of a palladium salt which is preferably $PdCl_2$, about 80 to 150 g/l of a stannous salt which is preferably $SnCl_2 \cdot 2H_2O$, and about 100 to 150 ml/l of an acid which is preferably HCl. When HCl is provided in the form of a 37% HCl solution, about 290 to 360 ml of the HCl solution is preferably employed. The most preferred composition contains about 1.5 g/l of $PdCl_2$, about 100 g/l of $SnCl_2$, and about 280 ml/l of 37% HCl. The composition is usually maintained at a temperature off 18.3 ± 12.2°C. It is believed that the palladium particles in the solution have associated therewith a negative charge as the pendant charge extending outward therefrom. In particular it is believed that the following occurs in the palladium chloride solution:

$$Sn^{++} + Pd^{++} \longrightarrow Pd° + Sn^{4+}$$

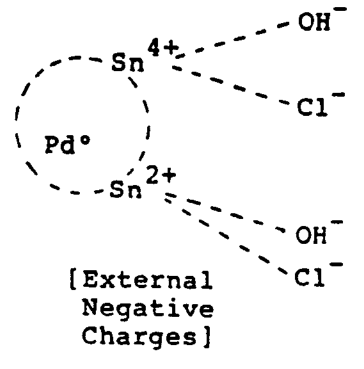


Accordingly, with a palladium stannous catalyst system, the ionic polymer is a cationic polymer (positively charged).

A typical triple seeder process includes first contacting the dielectric substrate surfaces and the holes, if present, with a stannous chloride sensitizing solution ($SnCl_2$/HCl). Typically, the contacting time is from 4 to 10 minutes with a preferred contact time of 7 minutes. Contacting the dielectric surface with this solution conditions the surfaces including the holes by depositing thereon a layer of $Sn^{2+}$. The stannous chloride is then rinsed from the substrate and holes with water. A hot water rinse being in a temperature range from 55°C to about 80°C is preferred. The hot water removes any excess stannous chloride and also hydrolyzes the $SnCl_2$ on the surface to produce gelatinous tin hydrous oxides which are adsorbed on the surface of the board as a stannous complex.

The next seeding step includes contacting the dielectric substrate surfaces and the hole surfaces, if present, with a palladium chloride activator in which divalent palladium interacts with the stannous compounds on the board surface to form an adherent layer of metallic palladium particles thereon. This may be accomplished by immersing the dielectric in the palladium activator bath for 2 ± 1 minute. This step promotes the adhesion of the final seeding step and increases the concentration of the final catalytic layer which is deposited in the final seeding step.

The third step of the seeding process includes contacting the substrate surface and hole surfaces, if present, with a palladium chloride/stannous chloride/hydrochloric acid seeder bath. While a preferred contact time of 5 minutes is desired, it has been found that the actual contact time can vary from 1 to 10 minutes and still provide satisfactory results. This step deposits the final catalytic layer which permits the additive metal, such as copper, to be placed electrolessly on the surface and in the holes of the dielectric substrate.

In preparing the solution for the first step of the process, it is found that the combination of stannous chloride having a content of between 53 and 57 g/l of $SnCl_2 \cdot 2H_2O$ with 37% hydrochloric acid at a ratio of 50 ml/l with the pH of the solution adjusted to a range between 0.2 and 0.5, provides a desired preconditioning solution. The $SnCl_2 \cdot 2H_2O$ is dissolved in the HCl with the resulting mixture being added to a tank of deionized water. It is generally found that the optimum results are obtained when the pH is approximately 0.4 and the solution is maintained at a temperature of 18.3 ± 12.2°C.

For the second step of the triple seeder process, the palladium chloride bath is formed by mixing 50 grams of palladium (with the concentration of 0.13 to 0.17 g/l) with approximately 3780 ml of 37% hydrochloric acid (having a concentration of 10 ml/l). The $PdCl_2$ is dissolved in the hydrochloric acid with the resultant mixture being added to a tank of deionized water. Again, the bath is maintained at a temperature of 18.3 ± 12.2°C, the pH is maintained between 0.75 and 1, and the copper content of the solution is kept below 50 parts per million.

The final catalytic palladium chloride/stannous chloride/hydrochloric acid seeder bath includes a bath comprising 1.2 to 2.5 g/l of $PdCl_2$ with 80 to 150 g/l of $SnCl_2 \cdot 2H_2O$ together with between 290 and 360 ml of 37% HCl per liter of solution. This third seeding bath is again maintained at a temperature of 18.3 ± 12.2°C. The optimum solution of the bath includes about 1.5 g/l of $PdCl_2$,

100 g/l of $SnCl_2$ and 280 ml/l of 37% hydrochloric acid.

As illustrated in Figure 7, the second resist layer is removed while leaving thhe first resist layer remaining on the substrate.

When the second resist layer is an aqueous strippable resist such as Riston 3515, the exposed portion can be removed by sodium hydroxide aqueous solution which concomitantly acts as an accelerator for the seeder in that it also removes the outer layer of tin from the colloidal particles.

This, in turn, leaves the palladium particles exposed and enables them to more effectively act as nucleating sites for the additive electroless plating.

The removal of the second resist layer results in removal of the seeder from the entire substrate, except for those portions where the seeder remains on the exposed substrate for subsequent electroless plating thereon (see Figure 7).

Next, a metal 6, such as nickel or copper, is plated by electroless plating onto the treated surface (see Figure 8).

The metal is coated to the desired thickness. The preferred metal employed is copper. The preferred copper electroless plating baths and their method of application are disclosed in U.S. Patents 3,844,799 and 4,152,467.

The copper electroless plating bath is generally an aqueous composition which includes a source of cupric ion, a reducing agent, a complexing agent for the cupric ion, and a pH adjustor. The plating baths also preferably include a cyanide ion source and a surface active agent.

The cupric ion source generally used is a cupric sulfate or a cupric salt of the complexing agent to be employed. When employing cupric sulfate, it is preferred to use amounts from about 3 to about 15 g/l and most preferably from about 8 to about 12 g/l. The most common reducing agent employed is formaldehyde which, in the preferred aspects, is used in amounts from about 0.7 to about 7 g/l and most preferably from about 0.7 to about 2.2 g/l. Examples of some other reducing agents include formaldehyde precursors or derivatives such as paraformaldehyde, trioxane, dimethyl hydantoin, and glyoxal; borohydrides such as alkali metal borohydrides (sodium and potassium borohydride) and substituted borohydrides such as sodium trimethoxy-borohydride; and boranes such as amine borane (isopropyl amine borane and morpholine borane). Hypophosphite reducing agents can also be used for electroless Ni and Cu plating.

Examples of some suitable complexing agents include Rochelle salts, ethylene diamine tetraacetic acid, the sodium (mono-, di-, tri-, and tetrasodium) salts of ethylene diamine tetraacetic acid, nitrilotetraacetic acid and its alkali salts, gluconic acid, gluconates, triethanol amine, glucono-(gamma)-lactone, modified ethylene diamine acetates such as N-hydroxyethyl ethylene diamine triacetate. In addition, a number of other suitable cupric complexing agents are suggested in U.S. Patents 2,996,408; 3,075,855; 3,075,856; and 2,938,805. The amount of complexing agent is dependent upon the amount of cupric ions present in the solution and is generally from about 20 to about 50 g/l, or in a 3—4 fold molar excess.

The plating bath can also contain a surfactant which assists in wetting the surface to be coated. A satisfactory surfactant is, for instance, an organic phosphate ester available under the trade designation "Gafac RE—610". Generally, the surfactant is present in amounts from about 0.02 to about 0.3 g/l. In addition, the pH of the bath is also generally controlled, for instance, by the addition of a basic compound such as sodium hydroxide or potassium hydroxide in the desired amount to achieve the desired pH. The preferred pH of the electroless plating bath is between 11.6 and 11.8.

Also preferably, the plating bath also contains a cyanide ion and most preferably contains about 10 to about 25 mg/l to provide a cyanide ion concentration in the bath within the range of 0.0002 to 0.0004 molar. Examples of some cyanides which can be employed are the alkali metal, alkaline earth metal, and ammonium cyanides. In addition, the plating baths can include other minor additives as is well-known in the prior art.

The preferred plating baths employed have a specific gravity within the range of 1.060 to 1.080. In addition, the temperature of the bath is preferably maintained between 70°C and 80°C and most preferably between 70°C and 75°C. For a discussion of the preferred plating temperatures coupled with the preferred cyanide ion concentrations, see U.S. Patent 3,844,799.

Also, the $O_2$ content of the bath can be maintained between about 2 ppm and 4 ppm and preferably about 2.5 to 3.5 ppm, as discussed in U.S. Patent 4,152,467. The $O_2$ content can be controlled by injecting oxygen and an inert gas into the bath.

The overall flow rate of the gases into the bath is generally from about 0.028 to about 0.566 standard $m^3$/min. per 3785 liters of bath and preferably from about 0.085 to about 0.227 standard $m^3$/min. per 3785 liters of bath.

Next, the layer of the first resist 2 can be removed, leaving the desired conductive pattern 6 on the substrate 1. When this layer is Riston T—168, the exposed material can be removed employing 1,1-dichloromethane. For certain applications it may be desirable to allow the first resist layer 2 to remain on substrate 1.

Masking processes employing two photoresist layers have been suggested, but such processes were not concerned with seeding or activating selected portions of a substrate. In particular, U.S. Patent 3,934,057 and U.S. Patent 4,180,604 relate to a structure comprising a substrate coated with two layers of photoresist which differ in their rate of dissolution in resist developer. After the layers of resist are developed, a metal film is deposited on the exposed substrate surface and the upper resist layer. A resist edge profile is produced which is desirable for metal lift-off.

These two patents do not suggest a sequence of steps for activating selected portions of a circuit board, but suggest processes wherein metal is plated on the upper photoresist layer as well as on the exposed substrate.

U.S. Patent 4,088,490 relates to a process for metallizing a substrate wherein two photoresist layers are employed. The two layers are separately exposed and developed with intervening steps of metal plating.

**Claims**

1. Process for activating a substrate for electroless deposition of a conductive metal on preselected portions of the substrate which comprises:

a) providing a first resist layer (2) onto a major surface of said substrate (1);

b) providing a second resist layer (3) onto the first resist layer (2), said second resist having different solubility characteristics than those of said first resist;

c) exposing said first and second layers (2, 3) of resist to imaging radiation in a predetermined pattern;

d) developing each of said first and second layers (2, 3) of resist;

e) seeding the resulting exposed substrate; and

f) removing the second resist layer (3) from the structure, thereby removing seeder, except from the exposed areas of substrate (1).

2. Process of claim 1 wherein the first resist layer (2) and the second resist layer (3) are negative resists.

3. Process of claim 2 wherein the second resist layer (3) is removed by an aqueous sodium hydroxide solution.

4. Process of claim 3 wherein the first resist layer (2) is removable by an organic solvent.

5. Process of claim 4 wherein said organic solvent is 1,1-dichloromethane.

6. The process of claim 1 wherein the thickness of said first resist layer (2) is about 0.025 to about 0.102 mm and the maximum thickness of said second resist layer (3) is about 0.013 mm.

7. Process of claim 6 wherein the thickness of the first resist layer (2) is about 0.038 to about 0.064 mm.

8. Process of claim 1 wherein said imaging radiation is U.V. light.

9. Process of claim 1 wherein first said resist layer (2) and said second resist layer (3) are applied by laminating.

10. Process of claim 1 which includes providing a composite of said first resist and second second resist and then providing the composite on said major surface.

11. Process of claim 1 wherein said first resist layer (2) is exposed to imaging radiation and, if desired, developed prior to providing the second resist layer (3) onto said first resist layer (2).

12. Process of claim 1 wherein prior to seeding, the substrate is contacted with a composition containing a multifunctional ionic polymer material containing at least two available ionic moieties, wherein said ionic moieties are of a charge opposite from the charge associated with the seeder particles to be subsequently applied to the substrate.

13. Process of claim 11 wherein said multifunctional ionic polymer material is a copolymer of acrylamide and ammonium quaternary compounds.

14. Process of claim 1 wherein the seeder includes palladium and tin.

15. Process for plating a substrate with a conductive metal on preselected portions of said substrate which comprises further to steps a) to f) of claim 1

g) contacting the substrate with an electroless plating bath containing ions of a conductive metal therein, and subsequently removing first resist layer (2).

16. Process of claim 15 wherein said conductive metal is nickel or copper.

**Patentansprüche**

1. Verfahren zum Aktivieren eines Substrats für die stromlose Abscheidung eines leitenden Metalls auf ausgewählten Teilen des Substrats, welches folgende Schritte umfaßt:

a) Aufbringen einer ersten Resistschicht (2) auf eine Hauptfläche des Substrats (1);

b) Aufbringen einer zweiten Resistschicht (3) auf die erste Resistschicht (2), wobei die zweite Resistschicht andere Löslichkeitseigenschaften als die erste Resistschicht hat;

c) Beaufschlagen der ersten und zweiten Resistschichten (2, 3) mit Strahlung zur Abbildung in einem bestimmten Muster;

d) Enwickeln jeder ersten und zweiten Resistschicht (2, 3);

e) Impfen des resultierenden freigelegten Substrats; und

f) Entfernen der zweiten Resistschicht und mit ihr der Impfsubstanz von der Struktur mit Ausnahme in den freigelegten Bereichen des Substrats (1).

2. Verfahren nach Anspruch 1, dadurch gekennzeichnet, daß die erste Resistschicht (2) und die zweite Resistschicht (3) negative Resists sind.

3. Verfahren nach Anspruch 2, dadurch gekennzeichnet, daß die zweite Resistschicht (3) mit einer wässrigen Natriumhydroxidlösung entfernt wird.

4. Verfahren nach Anspruch 3, dadurch gekennzeichnet, daß die erste Resistschicht (2) mit einem organischen Lösungsmittel entfernt wird.

5. Verfahren nach Anspruch 4, dadurch gekennzeichnet, daß die organische Lösungsmittel 1,1-Dichlormethan ist.

6. Verfahren nach Anspruch 1, dadurch gekennzeichnet, daß die Dicke der ersten Resistschicht (2) ungefähr 0,025 bis ungefähr 0,102 mm und die Obergrenze der Dicke der zweiten Resistschicht (3) ungefähr 0,013 mm beträgt.

7. Verfahren nach Anspruch 6, dadurch gekennzeichnet, daß die Dicke der ersten Resistschicht (2) ungefähr 0,038 bis ungefähr 0,064 mm beträgt.

8. Verfahren nach Anspruch 1, dadurch gekennzeichnet, daß die zur der Abbildung verwendete Strahlung ultraviolettes Licht ist.

9. Verfahren nach Anspruch 1, dadurch gekennzeichnet, daß die erste Resistschicht (2) und die zweite Resistschicht (3) durch Laminieren aufgebracht werden.

10. Verfahren nach Anspruch 1, dadurch gekennzeichnet, daß ein Verbund aus einer ersten und einer zweiten Resistschicht hergestellt und dann auf die Hauptfläche aufgebracht wird.

11. Verfahren nach Anspruch 1, dadurch gekennzeichnet, daß die erste Resistschicht (2) zur Abbildung mit Strahlung beaufschlagt und gegebenenfalls vor dem Aufbringen der zweiten Resistschicht (3) auf die erste Resistschicht (2) entwickelt wird.

12. Verfahren nach Anspruch 1, dadurch gekennzeichnet, daß das Substrat vor dem Impfen mit einer Zusammensetzung in Berührung gebracht wird, welche ein multifunktionelles ionisches Polymermaterial mit mindestens zwei verfügbaren ionischen Resten enthält, und daß die Ladung der ionischen Reste der Ladung der Impfpartikel, welche anschließend auf das Substrat aufzubringen sind, entgegengesetzt ist.

13. Verfahren nach Anspruch 11, dadurch gekennzeichnet, daß das multifunktionelle ionische Polymermaterial ein Copolymer des Acrylamid und quaternären Ammoniumverbindungen ist.

14. Verfahren nach Anspruch 1, dadurch gekennzeichnet, daß das Impfmaterial Palladium und Zinn enthält.

15. Verfahren zum Beschichten eines Substrats mit einem leitenden Metall in ausgewählten Teilen des Substrats, welches außer den Schritten a) bis f) von Anspruch 1 folgenden Schritt umfaßt

g) in Berührung bringen des Substrats mit einem Bad zur stromlosen Abscheidung, welches Ionen eines leitenden Metalls enthält, und anschließendes Entfernen der ersten Resistschicht (2).

16. Verfahren nach Anspruch 15, dadurch gekennzeichnet, daß das leitende Metall Nickel oder Kupfer ist.

**Revendications**

1. Procédé d'activation d'un substrat pour le dépôt sans courant d'un métal conducteur sur des parties prédéterminées du substrat, qui comprend:

a) la préparation d'une première couche photosensible (2) sur une surface principale dudit substrat (1);

b) la préparation d'une deuxième couche photosensible (3) sur la première couche photosensible (2), ladite deuxième couche photosensible ayant des caractéristiques de solubilité différentes de celles de ladite première couche photosensible;

c) l'exposition desdites première et deuxième couches (2, 3) de matière photosensible à un rayonnement de formation d'image suivant une configuration prédéterminée;

d) le développement de chacune des dites première et deuxième couches (2, 3) de matière photosensible;

e) l'ensemencement du substrat exposé résultant; et

f) l'enlèvement de la deuxième couche photosensible (3) de la structure, ce qui élimine la matière d'ensemencement sauf dans les zones exposées du substrat (1).

2. Procédé suivant la revendication 1, dans lequel la première couche photosensible (2) et la deuxième couche photosensible (3) sont des couches photosensibles négatives.

3. Procédé suivant la revendication 2, dans lequel la deuxième couche photosensible (3) est enlevée au moyen d'une solution aqueuse d'hydroxyde de sodium.

4. Procédé suivant la revendication 3, dans lequel la première couche photosensible (2) peut être enlevée au moyen d'un solvant organique.

5. Procédé suivant la revendication 4, dans lequel ledit solvant organique est le 1,1-dichlorométhane.

6. Procédé suivant la revendication 1, dans lequel l'épaisseur de ladite première couche photosensible (2) est de 0,025 mm environ à 0,102 mm environ et l'épaisseur maximale de ladite deuxième couche photosensible (3) est de 0,013 mm environ.

7. Procédé suivant la revendication 6, dans lequel l'épaisseur de la première couche photosensible (2) est de 0,038 mm environ à 0,064 mm environ.

8. Procédé suivant la revendication 1, dans lequel ledit rayonnement de formation d'image est une lumière ultraviolette.

9. Procédé suivant la revendication 1, dans lequel ladite première couche photosensible (2) et la dite deuxième couche photosensible (3) sont appliquées par laminage.

10. Procédé suivant la revendication 1, qui comprend la préparation d'un composite de ladite première matière photosensible et de ladite deuxième matière photosensible, puis l'application du composite sur ladite surface principale.

11. Procédé suivant la revendication 1, dans lequel ladite première couche photosensible (2) est exposée au rayonnement de formation d'image et, si on le désire, développée avant d'appliquer la deuxième couche photosensible (3) sur ladite première couche photosensible (2).

12. Procédé suivant la revendication 1, dans lequel, avant l'ensemencement, le substrat est mis en contact avec une composition contenant un polymère ionique multifonctionnel qui contient au moins deux groupements ioniques disponibles, lesdits groupements ioniques étant d'une charge opposée à la charge associée aux particules de matière d'ensemencement à appliquer ensuite au substrat.

13. Procédé suivant la revendication 11, dans lequel ledit polymère ionique multifonctionnel est un copolymère de composés d'acrylamide et d'ammonium quaternaire.

14. Procédé suivant la revendication 1, dans lequel la matière d'ensemencement comprend du palladium et de l'étain.

15. Procédé pour le dépôt d'un métal conducteur sur des parties prédéterminées d'un substrat, qui comprend, en plus des opérations a) à f) de la revendication 1:

g) la mise en contact du substrat avec un bain de placage sans courant contenant des ions d'un métal conducteur, et ensuite l'enlèvement de la première couche photosensible (2).

16. Procédé suivant la revendication 15, dans lequel ledit métal conducteur est le nickel ou le cuivre.

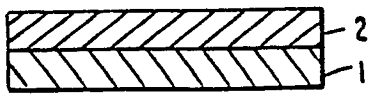


FIG.1

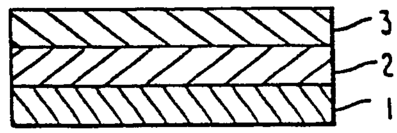


FIG.2

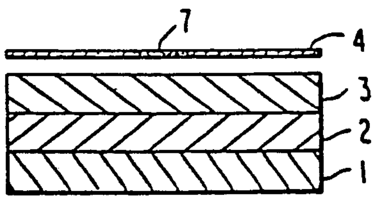


FIG.3

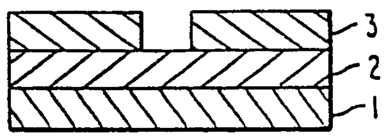


FIG.4

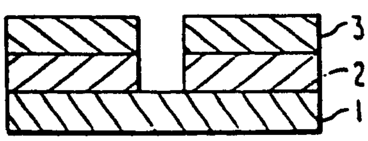


FIG.5

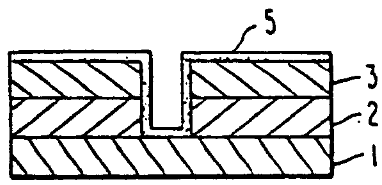


FIG.6

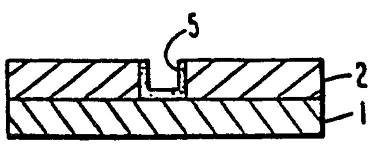


FIG.7

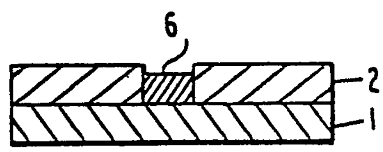


FIG.8

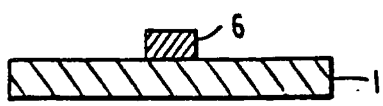


FIG.9